# EUROPÄISCHE PATENTSCHRIFT

(11) **EP 1 949 041 B1**
(45) Veröffentlichungstag und Bekanntmachung des Hinweises auf die Patenterteilung: **06.03.2013**
(21) Anmeldenummer: 06793824.1
(22) Anmeldetag: 26.09.2006
(51) Int. Cl.: B60R 19/48, G01P 1/02, G01P 15/00

(54) **BESCHLEUNIGUNGSSENSOR**
ACCELERATION SENSOR
CAPTEUR D'ACCELERATION

(30) Priorität: 08.11.2005 DE 102005053114
(43) Veröffentlichungstag der Anmeldung: 30.07.2008
(73) Patentinhaber: ROBERT BOSCH GMBH, 70442 Stuttgart (DE)
(72) Erfinder: SCHEDLER, Christian, 29351 Eldingen (DE); BRANDT, Tobby, 71034 Boeblingen (DE)
(86) Internationale Anmeldenummer: PCT/EP2006/066729
(87) Internationale Veröffentlichungsnummer: WO 2007/054397

(56) Entgegenhaltungen:
- EP-A1- 1 504 967
- EP-A2- 0 908 363
- DE-A1- 4 418 681
- DE-A1- 19 911 890
- DE-A1-102004 062 466
- JP-A- 9 159 689

## Beschreibung

### Stand der Technik

Die Erfindung betrifft einen Beschleunigungssensor nach der Gattung des unabhängigen Patentansprüchs.

Aus DE 103 48 386 A1 ist es bereits bekannt, einen Fußgängeraufprall mittels Beschleunigungssensoren zu erfassen. Aus DE 10 004 062 466 A1 ist ein Gehäusesystem für Fahrzeugsensoren einschließlich Beschleunigungssensoren bekannt. DE 102004062466 A1 zeigt einen Beschleunigungssensor entsprechend dem Oberbegriff des Anspruchs 1. Dabei wird eine kostengunstige Lösung vorgeschagen, für die lösbare und unlösbare Verbindungsmittel für die Befestigung des Gehäuses und des Sensors am Fahrzeug verwendet werden können. Das Befestigungsmittel zwischen Sensor und dem Sensorgehäuse kommen lösbare und unlösbare Verbindungen wie Klebungen, mechanische Steckverbindungen oder ein Rastverschluss in Frage. Aus DE 199 11 890 A1 ist ein Sensorhalter für ein Trägerteil bekannt, wobei ein Verbindungselement, über das der Sensorhalter mit dem Trägerteil verschweißbar ist, vorgesehen ist und derart ausgebildet ist, dass es aus einem Laserdurchlässigen Kunststoffmaterial gefertigt ist.

### Offenbarung der Erfindung

Der Beschleunigungssensor mit den Merkmalen des unabhängigen Patentansprüchs hat dem gegenüber den Vorteil, dass eine einfache Befestigung eines Beschleunigungssensors an die Stoßfängerverkleidung zur Erfassung eines Fußgängeraufpralls ermöglicht wird. Insbesondere können Standardsensorgehäuse verwendet werden, die bereits heute auf dem Markt sind. Insbesondere ist durch die Erfindung eine gute Signalkoppelung zwischen Stoßtängerverkleidung und dem Sensorelement gewährteistet, Dazu ist der Sensorhalter derart ausgeführt, dass er keine zusätzlichen Beschleunigungssignale, z. B durch Eigenschwingungen verursacht. Vorteil ist dabei, dass herkömmliche Sensorgehäuse venvendet werden können und eine Integration selbst dann möglich ist, wenn der Stoßfänger nicht speziell für die Integration von Fußgängerschutzsensoren entwickelt wurde. Dies wird dadurch gewährteistet, dass der Sensorhalter entweder aus dem gleichen Kunststoffmaterial wie die Stoßfängerverkleidung, insbesondere im Falle der Ultraschallverschweißung wie die Stoßfängerrückseite, besteht oder ans einem anderem Kunststoff, der in seinen Materialeigenschaften denjeweiligen Einsatzbedingungen angepasst werden kann, der dann über einen Klebeprozess befestigt wird. Der Sensorhalter kann dadurch individuell an den vorhandenen Bauraum und an das beim Automobilhersteller vorhandene Sensorgehäuse angepasst werden.

Ein weiterer Vorteil ist, dass sich die Sensorintegration so realisieren lässt, dass das so genannte Lower Leg Kriterium erfüllt wird. D. h. die Sensoren können so in den Stoßfänger integriert werden, dass der Stoßfänger an den möglichen Anprallorten nicht zusätzlich versteift wird.

Für die Realisierung ist nur ein Fixierstift und ein Fixierloch notwendig. Vorzugsweise werden jedoch mindestens zwei Fixierstife und mindestens zwei Fixierlöcher verwendet.

Der Sensorhalter weist wenigstens eine Verstärkung aus. Diese Verstärkung dient dazu. Eigenschwingungen des Sensorhalters zu unterdrücken. insgesamt wird dadurch die Stabilität des Sensorhalters verbessert.

Durch die in den abhängigen Ansprüchen aufgeführten Maßnahmen und Weiterbildungen sind vorteilhafte Verbesserungen des im unabhängigen Patentanspruch angegebenen Beschleunigungssensors bzw. der Stoßfängerverkleidung möglich.

Weiterhin ist es vorteilhaft, dass der Halter mit zwei Stirnflächen an der Stoßfängerverkleidung befestigt wird während eine mittlere Fläche, die davon beabstandet ist, zur Aufnahme des Sensorgehäuses dient. Dafür weist diese mittlere Fläche eine Blindnietmutter mit einem Innengewinde auf, sodass das Sensorgehäuse in diese Blindnietmutter verschraubt werden kann. Die Beabstandung wird durch senkrecht auf den Befestigungsflächen angebrachte Flächen realisiert.

Weiterhin ist es vorteilhaft, dass der Sensorhalter zwei weitere Flächen zu der Fläche mit der Blindnietmutter aufweist, wobei diese beiden weiteren Flächenjeweils 90° zu der Fläche mit der Blindnietmutter versetzt sind. Dies ermöglicht, andere Sensorgehäuse zu befestigen, je nach Sensorrichtung des Beschleunigungssensors.

### Zeichnung

Ausführungsbeispiele der Erfindung sind in der Zeichnung dargestellt und werden in der nachfolgenden Beschreibung näher erläutert. Die Figuren 1 und 2 zeigen ein erstes Ausführungsbeispiel, Figur 3 bis 5 ein zweites und drittes Ausführungsbeispiel, Figur 6 und 7 ein viertes und fünftes Ausführungsbeispiel.

### Beschreibung

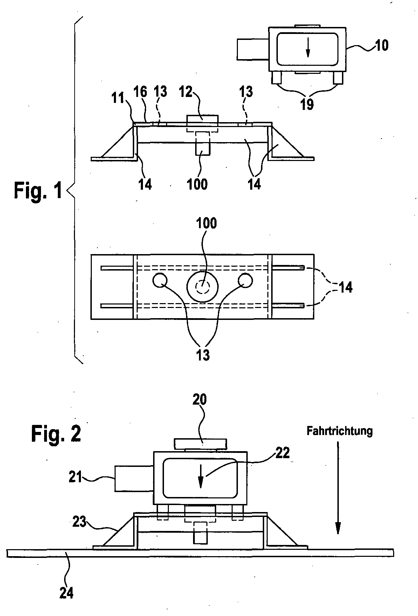

Figur 1 zeigt eine Explosionsdarstellung des erfindungsgemäßen Beschleunigungssensors. Das Gehäuse 10 des Sensors wird auf einen Halter 11 aufgebracht. Das Sensorgehäuse 10 nimmt ein Sensorelement auf, das eine Sensierrichtung in Richtung des Halters aufweist. Dies ist durch den Pfeil auf dem Sensorgehäuse 10 angedeutet. Der Halter 11 weist eine Blindnietmutter mittig auf, die ein Innengewinde aufweist. Das Gehäuse 10 weist Fixierstifte 19 auf, die in Fixierlöcher 13 im Halter 11 hineingeschoben werden, um das Sensorgehäuse 10 optimal zu fixieren. Beispielhaft sind hier zwei Fixierstifte und zwei Fixierlöcher dargestellt; es ist jedoch möglich, lediglich einen Fixierstift und ein Fixierloch oder auch mehr als zwei Fixierstifte und entsprechende Fixierlöcher zu verwenden. Die Befestigungsflächen 17 und 18 sind mit Verstärkungen 14 versehen, um Eigenschwingungen zu unterdrücken. Die Flächen 17 und 18 sind parallel zur Fläche 16 angeordnet.
Figur 2 zeigt den zusammen gebauten Zustand. Nunmehr ist durch eine Schraube 20 das Sensorgehäuse 21 mit dem Halter 23 verbunden. Die Schraube 20 wurde dabei in die Blindnietmutter, und zwar dort in das Innengewinde eingeschraubt. Die Sensierrichtung 22 zeigt hier in die Fahrtrichtung. Der Halter 23 ist auf der Stoßfängerverkleidung 24 angeordnet, und zwar befestigt durch Ultraschallschweißen. Stoßfängerverkleidung und der Halter 23 sind beide aus Kunststoff gefertigt. Dies gilt natürlich nicht für Hülsen und Ringe, die dann aus Metall gefertigt sind.

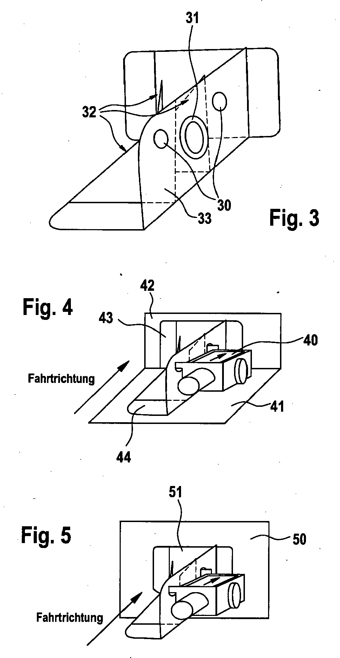

Figur 3 zeigt ein weiteres Ausführungsbeispiel des erfindungsgemäßen Sensorhalters. Der Sensorhalter besteht aus drei Flächen, die jeweils zueinander 90° versetzt sind. Die Fläche 33 weist eine Blindnietmutter 31 und die Fixierungslöcher 30 auf. Auf den anderen Flächen sind Verstärkungen 32 angeordnet, um gegen Eigenschwingungen zu schützen.
Figur 4 zeigt eine Befestigungsform mit dem in Figur 3 vorgestellten Halter. Ein Sensorgehäuse 40 mit einem Sensorelement, das 90° bezüglich der Sensierrichtung versetzt ist, ist auf der Fläche 33 durch die Blindnietmutter und einer Schraube befestigt. Auch hier stimmen Fahrtrichtung und Sensierrichtung 40 überein. Die Fläche 43 mit den Verstärkungen ist auf der Fläche 42 der Stoßfängerverkleidung angeordnet. Auch die Fläche 44 des Halters ist auf der Fläche 41 der Stoßfängerverkleidung angebracht. Die Verbindung wurde auch hier durch Ultraschallschweißen bewerkstelligt. Figur 5 zeigt eine Variante. Es ist der gleiche Halter mit einem gleichen Sensorgehäuse, jedoch ist hier nur die Fläche 51 mit der Fläche 50 der Stoßfängerverkleidung mittels Ultraschallschweißen verbunden. Der in den Figuren 3 bis 5 vorgestellte Halter hat damit eine hohe Flexibilität bezüglich der Befestigung.

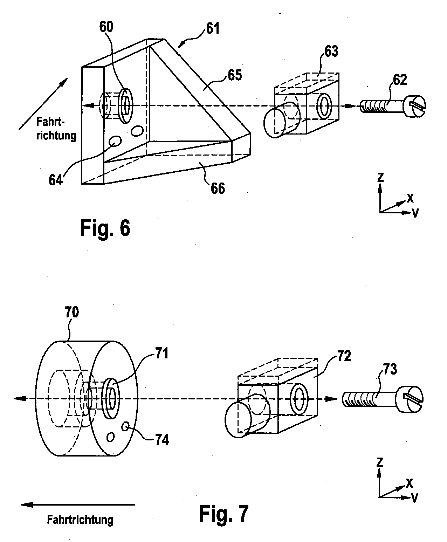

Figur 6 zeigt eine Explosionsdarstellung des erfindungsgemäßen Beschleunigungssensors. Im Halter 61 ist eine Nietmutter 60 vorgesehen. Daraufwird das Sensorgehäuse 63 mit der Schraube 62 befestigt. Weiterhin ist mindestens ein Fixierloch 64 vorgesehen, damit eine Drehung des Sensors und damit eine Verfälschung der Sensierrichtung ausgeschlossen ist. Der Halter ist durch die Anordnung der Flächen und durch die Stärke des Materials so ausgelegt, dass Eigenschwingungen unterdrückt werden. Der Halter 61 wird mit mindestens einer Fläche 65 oder 66 an die Stoßfängerverkleidung angebracht. Die Flächen 65 und 66 können dabei individuell an die Form des Montageortes angepasst werden.
Figur 7 unterscheidet sich gegenüber Figur 6 dahingehend, dass nunmehr ein Sensorgehäuse verwendet werden kann, in dem sich ein Sensorelement befindet, dass eine Sensierrichtung aufweist, welche gegenüber der Längsachse des Sensorgehäuses um 90° versetzt ist. Wiederum ist der Sensorhalter 70 mit einer Nietmutter 71 und mindestens einem Fixierloch 74 versetzt, um eine Verschraubung des Sensorgehäuses 72 mittels der Schraube 73 zu ermöglichen.

## Patentansprüche

1. Beschleunigungssensor zur Befestigung an eine Stoßfängerverkleidung zur Erfassung eines Fußgängeraufpralls, mit einem Sensorelement, das in einem Sensorgehäuse (10, 23) vorgesehen ist, **dadurch gekennzeichnet, dass** das Sensorgehäuse (10, 23) wenigstens einen Fixierstift (19) und eine Durchführung für eine Schraube (20) aufweist, dass ein Sensorhalter (10, 23) vorgesehen ist, der an der Stoßfängerverkleidung befestigbar ist, weitgehend aus Kunststoff hergestellt ist und eine Blindnietmutter (12) mit einem Innengewinde sowie wenigstens ein Fixierloch (13) zur Aufnahme des wenigstens einen Fixierstifts (19) aufweist, wobei der Sensorhalter (10, 23) entweder aus dem gleichen Kunststoffmaterial wie die Stoßfängerverkleidung im Falle der Ultraschallverschweißung oder aus einem anderen Kunststoff besteht, der in seinen Materialeigenschaften den jeweiligen Einsatzbedingungen anpassbar ist und über einen Klebeprozess befestigbar ist, wobei das Sensorgehäuse (10, 21) mit dem Sensorhalter (11, 23) mittels einer Schraube (20) und der Blindnietmutter (100) verschraubbar ist, wobei der Sensorhalter (11, 23) wenigstens eine Verstärkung (14) zur Unterdrückung von Eigenschwingungen des Sensorhalters (10, 23) aufweist.

2. Beschleunigungssensor nach Anspruch 1, **dadurch gekennzeichnet, dass** der Sensorhalter (11, 23) eine mittlere erste Fläche (16) mit der Blindnietmutter (100) aufweist, wobei eine zweite und dritte parallele Fläche (17, 18) zu der ersten Fläche (16) beabstandet sind.

3. Beschleunigungssensor nach Anspruch 1, **dadurch gekennzeichnet, dass** der Sensorhalter (11, 23) eine vierte Fläche mit Blindnietmutter aufweist, wobei der Sensorhalter zusätzlich eine fünfte und sechste Fläche aufweist, die jeweils 90° zu der vierten Fläche angeordnet sind.

## Claims

1. Acceleration sensor for fastening to a bumper cladding for detecting a pedestrian impact, with a sensor element which is provided in a sensor housing (10, 23), **characterized in that** the sensor housing (10, 23) has at least one fixing pin (19) and a bushing for a screw (20), **in that** a sensor holder (10, 23) is provided, the sensor holder being fastenable to the bumper cladding, being substantially produced from plastic and having a blind rivet nut (12) with an internal thread and at least one fixing hole (13) for receiving the at least one fixing pin (19), wherein the sensor holder (10, 23) is either composed of the same plastics material as the bumper cladding, in the case of ultrasonic welding, or of a different plastic which is adaptable in the material characteristics thereof to the respective use conditions and is fastenable via an adhesive bonding process, wherein the sensor housing (10, 21) is screwable to the sensor holder (11, 23) by means of a screw (20) and the blind rivet nut (100), wherein the sensor holder (11, 23) has at least one reinforcement (14) for suppressing natural vibrations of the sensor holder (10, 23).

2. Acceleration sensor according to Claim 1, **characterized in that** the sensor holder (11, 23) has a central first surface (16) with the blind rivet nut (100), wherein a second and third parallel surface (17, 18) are spaced apart from the first surface (16).

3. Acceleration sensor according to Claim 1, **characterized in that** the sensor holder (11, 23) has a fourth surface with a blind rivet nut, wherein the sensor holder additionally has a fifth and sixth surface which are each arranged at 90° with respect to the fourth surface.

## Revendications

1. Capteur d'accélération pouvant être fixé à un habillage de pare-chocs en vue de détecter un choc de piéton ;
avec un élément de capteur prévu dans un carter de capteur (10, 23) ;
**caractérisé en ce que** :
le carter de capteur (10, 23) comporte au moins une tige de fixation (19) et un guide traversant prévu pour une vis (20) ;
un porte-capteur (10, 23) est prévu pouvant être fixé à l'habillage de pare-chocs, fabriqué en grande mesure en matière plastique et comportant un écrou de rivet aveugle (12) pourvu d'un filet intérieur ainsi qu'au moins un trou de fixation (13) servant à recevoir l'au moins une tige de fixation (19) ;
le porte-capteur (10, 23) se composant soit de la même matière plastique que l'habillage de pare-chocs dans le cas d'une soudure aux ultrasons soit d'une autre matière plastique dont les propriétés de matériau peuvent être adaptées en fonction des conditions d'utilisation respectives et pouvant être fixée par le biais d'un procédé de collage ;
le carter de capteur (10, 21) pouvant être vissé au porte-capteur (11, 23) à l'aide d'une vis (20) et de l'écrou de rivet aveugle (100) ;
le porte-capteur (11, 23) comportant au moins un renfort (14) permettant de contenir les vibrations propres du porte-capteur (10, 23).

2. Capteur d'accélération selon la revendication 1, **caractérisé en ce que** le porte-capteur (11, 23) comporte une première surface (16) centrale pourvue de l'écrou de rivet aveugle (100), des deuxième et troisième surfaces parallèles (17, 18) étant placées à une certaine distance de la première surface (16).

3. Capteur d'accélération selon la revendication 1, **caractérisé en ce que** le porte-capteur (11, 23) comporte une quatrième surface comprenant l'écrou de rivet aveugle, le porte-capteur comportant en outre une cinquième et une sixième surface respectivement disposées à 90° par rapport à la quatrième surface.
